# FASCICULE DE BREVET EUROPEEN

(11) **EP 4 418 052 B1**
(45) Date de publication et mention de la délivrance du brevet: **26.08.2026**
(21) Numéro de dépôt: 23156908.8
(22) Date de dépôt: 15.02.2023
(51) Int. Cl.: G04D 3/02, G04B 45/00, B21K 1/56, C21D 7/08, B23P 9/04, B23P 15/00, B26B 25/00, B23G 9/00, B23P 25/00, B23C 5/08

(54) **PROCÉDÉ DE FABRICATION D'UN ÉLÉMENT DE FIXATION MICROMÉCANIQUE, ET OUTIL DE MISE EN FORME POUR LA RÉALISATION D'UNE EMPREINTE DE L'ÉLÉMENT DE FIXATION MICROMÉCANIQUE**
VERFAHREN ZUR HERSTELLUNG EINES MIKROMECHANISCHEN BEFESTIGUNGSELEMENTS, UND FORMWERKZEUG ZUR HERSTELLUNG EINES ABDRUCKS DES MIKROMECHANISCHEN BEFESTIGUNGSELEMENTS
METHOD FOR PRODUCING A MICROMECHANICAL FIXING ELEMENT, AND SHAPING TOOL FOR CREATING A RECESS IN THE MICROMECHANICAL FIXING ELEMENT

(43) Date de publication de la demande: 21.08.2024
(60) Demande divisionnaire: 26173457.8 / 4 775 339
(73) Titulaire: Nivarox-FAR S.A., 2400 Le Locle (CH)
(72) Inventeur: HAEFELI, Frédéric, 2720 Tramelan (CH); ZBINDEN, Raphaël, 2014 Bôle (CH); DUBIEF, Mickaël, 90100 Chavannes les Grands (FR); THEURILLAT, Raphaël, 2900 Porrentruy (CH)
(74) Mandataire: ICB SA

(56) Documents cités:
- CH-A- 316 474
- CN-A- 103 111 918
- CN-U- 204 195 173
- FR-A- 494 828
- JP-A- 2009 220 225

## Description

### Domaine technique de l'invention

L'invention relève du domaine de la fabrication de pièces micromécaniques. L'invention concerne plus particulièrement un outil de mise en forme pour la réalisation d'une empreinte d'un élément de fixation micromécanique, un procédé de fabrication de l'élément de fixation micromécanique.

La présente invention trouve une application avantageuse dans le domaine de l'horlogerie.

### Arrière-plan technologique

Dans le domaine de la micromécanique, notamment dans le domaine de l'horlogerie, l'aspect esthétique des pièces mécaniques d'un assemblage, par exemple d'un mouvement horloger ou d'une boite de montre, revêt une grande importance. Notamment, l'état des surfaces visibles des pièces constituant l'assemblage doit être maitrisé.

A cet effet, certaines surfaces planes sont polies ou sont décorées par des étapes d'enlèvement de matière afin de leur donner un relief particulier, tel que le guillochage, le soleillage, le perlage, etc.

Toutefois, les surfaces difficiles d'accès de certaines pièces sont laissées en l'état après usinage du fait de leurs très faibles dimensions. De telles surfaces peuvent être constituées par exemple par les surfaces de fond d'empreintes d'éléments de fixation micromécaniques, tels que le fond de fentes de vis. Le document CH 316 474 A décrit un tour automatique pourvu d'un appareil à fendre des vis.

Seules les conditions d'usinage des empreintes sont alors déterminantes pour définir l'état de surface final de ces surfaces de fond d'empreintes. En particulier, cet état de surface est dépendant des phénomènes vibratoires en présence lors de l'usinage. Ces derniers étant très peu maitrisés du fait des très faibles dimensions de l'outil de coupe et de la pièce à usiner, la surface de fond d'empreinte d'un nombre important de pièces usinées ne présente pas un état de surface conforme aux exigences de fabrication.

Le nombre de rebuts est encore plus élevé lorsque les éléments de fixation sont destinés aux acteurs de la haute horlogerie, dans la mesure où leurs exigences en matière de finition et de qualité des surfaces sont très importantes.

Il existe donc un besoin de fabriquer des éléments de fixation dont l'ensemble des surfaces visibles présente un état de surface maitrisé de sorte à répondre aux exigences les plus strictes.

### Résumé de l'invention

L'invention résout les inconvénients précités en proposant une solution permettant de réaliser un élément de fixation micromécanique, tel qu'une vis ou autre élément de serrage, comprenant une empreinte prévue pour coopérer avec un outil de serrage pour l'application d'un couple de serrage, en maitrisant l'état des surfaces visibles de l'empreinte.

En outre, un des buts recherchés de la solution de l'invention est de pouvoir maitriser les coûts de fabrication de l'élément de fixation.

À cet effet, un aspect de la présente invention concerne un procédé de fabrication d'un élément de fixation micromécanique tel que défini dans la revendication 1 annexée.

Avantageusement, l'étape de matage permet de modifier l'état de la surface cible après usinage afin qu'elle réponde aux exigences de fabrication. En particulier, cette étape de matage permet, lors de la fabrication de l'élément de fixation, d'améliorer l'état de la surface cible, c'est-à-dire de minimiser les défauts géométriques de ladite surface à l'échelle micrométrique, par déformation plastique de la matière sous l'effet d'une pression locale générée par l'organe de matage.

Dans des modes particuliers de mise en œuvre, l'invention peut comporter en outre l'une ou plusieurs des caractéristiques suivantes, prises isolément ou selon toutes les combinaisons techniquement possibles.

Dans des modes particuliers de mise en œuvre, lors de la réalisation de l'ensemble de l'étape de formation de l'empreinte, l'élément de fixation est maintenu dans une même position, seul l'outil de mise en forme étant déplacé.

Dans des modes particuliers de mise en œuvre, la surface cible matée est une surface de fond de l'empreinte, l'opération de matage étant réalisée de sorte que ladite surface de fond présente un Ra compris entre 0.01 µm et 0.1 µm à l'issue de l'étape de formation.

Dans des modes particuliers de mise en œuvre, lors de la mise en œuvre des opérations d'usinage et de matage, l'outil de mise en forme est entraîné dans des sens de rotation différents, l'organe de coupe et l'organe de matage étant agencés sur un même disque de l'outil de mise en forme.

Dans des modes particuliers de mise en œuvre, lors des opérations d'usinage et de matage, l'ébauche est usinée par un organe de coupe et matée par un organe de matage formés chacun par un disque de l'outil de mise en forme, lesdits disques étant parallèles et coaxiaux.

Dans des modes particuliers de mise en œuvre, l'opération de matage est mise en œuvre par une pluralité de passes successives de l'organe de matage sur la surface cible, chaque passe étant réalisée à une profondeur de passe comprise entre 0,1 µm et 2 µm ou entre 0,5 µm et 1,5 µm.

Selon un autre objet, la présente invention concerne un outil de mise en forme, tel que défini par la revendication 7 annexée, pour la réalisation d'une empreinte d'un élément de fixation micromécanique. L'outil de mise en forme est avantageusement adapté à réaliser le procédé de fabrication précité.

L'outil de mise en forme comprend un corps s'étendant selon un axe longitudinal autour duquel l'outil est destiné à être entraîné en rotation. L'outil de mise en forme comprend en outre, agencés à une extrémité longitudinale du corps, un organe de coupe comprenant une arête de coupe destinée à enlever de la matière d'un élément de fixation de sorte à générer une empreinte lorsque l'outil est entraîné en rotation, et un organe de matage comprenant une surface active destinée à mater une surface cible de l'empreinte lorsque l'outil est entraîné en rotation, chacun des organes de coupe et de matage est sous la forme d'un disque, les disques étant agencés parallèlement et coaxialement, les arêtes de coupe et la surface active étant respectivement agencées en périphérie desdits disques.

Dans des modes particuliers de réalisation, la surface active de l'organe de matage présente une section droite de forme circulaire.

Dans des modes particuliers de réalisation, la surface active de l'organe de matage présente une section droite de forme polygonale, comprenant des segments reliés entre eux par des sommets arrondis.

Dans des modes particuliers de réalisation, les segments présentent une courbure concave.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- la figure 1 représente schématiquement une vue en plan d'un outil de mise en forme selon une première forme de réalisation de l'invention ;
- la figure 2 représente une vue en coupe transversale selon l'axe de coupe A-A d'un organe de coupe de l'outil de mise en forme de la figure 1 ;
- la figure 3 représente une vue en coupe transversale selon l'axe de coupe B-B d'un organe de matage de l'outil de mise en forme de la figure 1 ;
- la figure 4 représente schématiquement une vue en plan d'un outil de mise en forme selon une forme de réalisation proche de l'invention.

On note que les figures ne sont pas nécessairement dessinées à l'échelle pour des raisons de clarté.

### Description détaillée de l'invention

Un premier aspect de la présente invention concerne un procédé de fabrication d'un élément de fixation micromécanique, par exemple une vis, et préférentiellement une vis d'horlogerie, destinée à être visible pour un utilisateur. Cet élément de fixation micromécanique est réalisé dans un matériau métallique, tel qu'en acier, en titane, etc., et est préférentiellement destiné au domaine de l'horlogerie, mais peut être de manière générale adaptée pour être utilisé dans tous domaines micromécaniques.

Le procédé comporte une étape de réalisation d'une ébauche de l'élément de fixation comprenant une tête et une tige reliées l'une à l'autre, suivi d'une étape de formation d'une empreinte dans la tête.

Cette empreinte s'étend depuis une ouverture jusqu'à une surface de fond et est avantageusement destinée à recevoir une tête d'un outil de serrage, tel qu'un tournevis, afin d'appliquer un couple sur l'élément de fixation. Dans ce cas, l'étape de réalisation de l'ébauche peut comporter une opération de filetage afin de réaliser un filet sur la tige de l'ébauche. Alternativement, l'empreinte peut uniquement présenter un rôle décoratif.

Dans tous les cas, la tête de l'élément de fixation, et donc l'empreinte, est destinée à être visible pour un utilisateur. L'empreinte peut présenter toute forme appropriée, par exemple présenter une section droite cruciforme, polygonale, etc. ou présenter une forme de fente rectiligne.

Avantageusement, l'étape de formation de l'empreinte comprend à la fois une opération d'usinage de l'empreinte réalisée avec un organe de coupe 11 et une opération de matage d'une surface cible de l'empreinte réalisée avec un organe de matage 12. La surface cible de l'empreinte est destinée à être visible pour un utilisateur et constitue préférentiellement le fond de l'empreinte.

Grâce à ces caractéristiques, les surfaces de l'empreinte, et en particulier le fond de l'empreinte, présentent un état de surface maitrisé, par exemple poli, qui lui permet de répondre de manière favorable aux exigences les plus strictes en terme d'aspect. En effet, l'opération de matage est réalisée de sorte que ladite surface de fond présente un Ra compris entre 0.01 µm et 0.1 µm, préférentiellement entre 0.02 µm et 0.05 µm, à l'issue de l'étape de formation de l'empreinte.

Il résulte aussi de ces caractéristiques que, grâce au procédé selon l'invention, il est possible de réaliser des éléments de fixation micromécanique de manière industrielle avec une excellente répétabilité, ce qui permet de réduire fortement ou d'éliminer les rebuts de fabrication. En outre, le fait de réaliser les opérations d'usinage et de matage dans une même étape du procédé permet d'optimiser la durée de fabrication d'un élément de fixation et d'en maitriser les coûts.

L'opération d'usinage est réalisée de sorte que l'empreinte présente une profondeur comprise entre 0,05 et 0,5 mm, par exemple comprise entre 100 µm et 200 µm, tel que 170 µm, et à cette effet, peut être réalisée en une ou plusieurs passes de l'organe de coupe 11. En particulier, l'opération d'usinage peut être réalisée par une passe d'ébauche suivie d'une passe de finition, cette dernière étant par exemple d'une profondeur de quelques micromètres, par exemple de 2 µm.

Concernant l'opération de matage, elle peut être mise en œuvre par une pluralité de passes successives de l'organe de matage 12 sur la surface cible, par exemple trois passes, chaque passe étant réalisée à une profondeur de passe comprise entre 0,1 µm et 2 µm, et préférentiellement entre 0,5 µm et 1,5 µm, par exemple 1 µm. Ainsi, la matière de la surface cible est écrouie par l'organe de matage 12, ce qui permet de sensiblement aplanir la surface cible à l'échelle micrométrique ou submicrométrique et donc d'améliorer son état de surface.

Avantageusement, l'étape de formation de l'empreinte peut être réalisée avec un unique outil de mise en forme 10 décrit ci-après en détail selon un autre aspect de la présente invention, sur lequel est agencé l'organe de coupe 11 et l'organe de matage 12. Un tel outil de mise en forme 10 est destiné à être fixé à un porte-outil d'un centre d'usinage afin d'être entraîné en rotation afin de réaliser l'empreinte de l'élément de fixation.

Le procédé peut comporter une étape de finition dans laquelle la surface externe de la tête, c'est-à-dire la surface délimitant la tête à l'exception de la surface de l'empreinte, est polie.

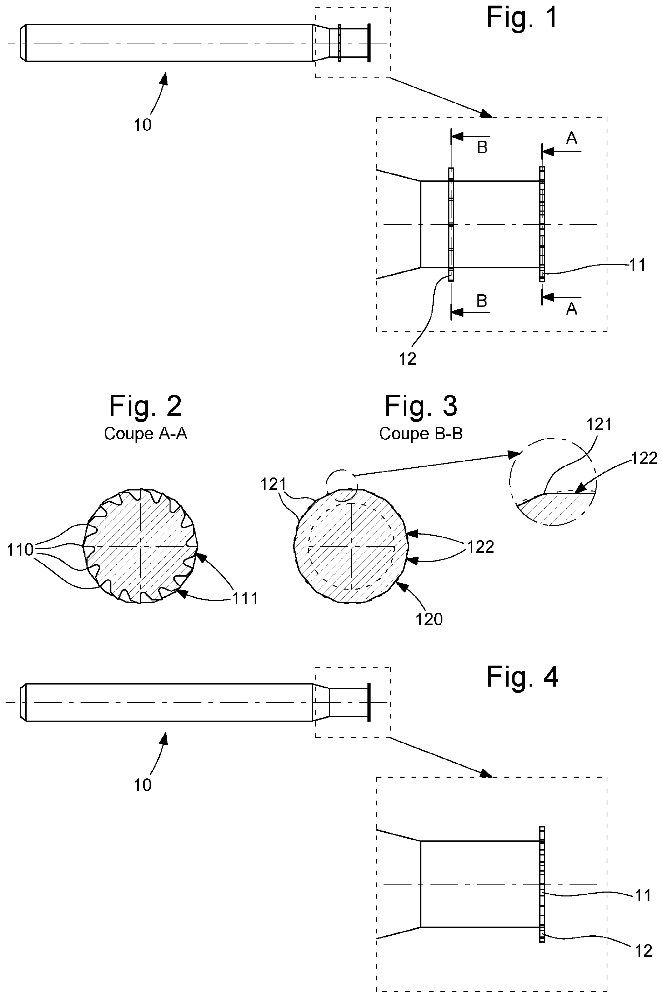

Comme visible sur la figure 1, l'outil de mise en forme 10 comprendre un corps, par exemple sous la forme d'un tasseau, s'étendant selon un axe longitudinal constituant l'axe de rotation de l'outil. L'organe de coupe 11 et l'organe de matage 12 sont agencés à l'extrémité libre du corps. L'organe de coupe 11 comprend une arête de coupe 110 destinée à enlever de la matière dans la tête de l'élément de fixation de manière à former l'empreinte lorsque l'outil est entraîné en rotation. L'organe de matage 12 comprend une surface active 120 destinée à mater la surface cible de l'empreinte lorsque l'outil est entraîné en rotation.

Avantageusement, lors de la réalisation de l'ensemble des opérations de l'étape de formation de l'empreinte, l'élément de fixation est maintenu dans une même position, seul l'outil de mise en forme 10 étant déplacé afin de réaliser les différentes passes. Le respect des tolérances d'usinage se trouve donc amélioré.

Dans une première forme de réalisation, l'organe de coupe 11 et l'organe de matage 12 sont formés chacun par un disque de l'outil de mise en forme 10, lesdits disques étant parallèles et coaxiaux. Une telle conception de l'outil de mise en forme 10 est représentée sur la figure 1. Comme visible sur les figures 2 et 3, les arêtes de coupe 110 et la surface active 120 sont respectivement agencées en périphérie desdits disques. A titre d'exemple, les disques peuvent présenter un diamètre de quelques millimètres, par exemple de 4 mm.

Comme visible sur la figure 2, l'organe de coupe 11 présente une forme d'une fraise circulaire. Cet organe de coupe 11 comporte une pluralité de dents périphériques, par exemple seize dents, régulièrement réparties, chaque dent comprenant à son sommet une face de dépouille 111. Les faces de dépouille 111 définissent, avec une face d'attaque de chaque dent, l'arête de coupe 110 de l'organe de coupe 11.

Dans cette forme de réalisation, l'organe de matage 12 peut présenter une section droite de forme sensiblement polygonale, comme illustrée sur la figure 3, comprenant des segments 122 reliés entre eux par des sommets 121 arrondis. Dans l'exemple préféré de réalisation, l'organe de matage 12 comporte quatorze sommets 121 et ces derniers présentent un rayon de quelques dixièmes de millimètres. Les segments 122 peuvent être rectilignes ou peuvent présenter une courbure concave dimensionnée de sorte qu'elle présente un écart maximal avec un cercle théorique passant par les sommets 121 de quelques centièmes de millimètres, comme le montre la vue de détail de la figue 3.

Alternativement, dans des exemples de réalisation de l'invention non représentés sur les figures, la surface active 120 de l'organe de matage 12 peut présenter une section droite de forme circulaire.

Dans une forme de réalisation proche de l'invention représentée sur la figure 4, les organes de coupe 11 et de matage 12 sont sous la forme d'un même disque. Ce disque présente sensiblement la même forme que le disque de la première forme de réalisation constituant l'organe de coupe 11 représenté sur la figure 2. Ce disque est configuré de sorte que lorsque l'outil est entraîné selon un premier sens de rotation, l'organe de coupe 11 est actif et l'organe de matage 12 est inactif, et lorsqu'il est entraîné dans un second sens de rotation opposé au premier sens de rotation, l'organe de coupe 11 est inactif et l'organe de matage 12 est actif. Plus précisément, la face de dépouille 111 forme la surface active 120 de l'organe de matage 12.

De manière plus générale, il est à noter que les modes de mise en œuvre et de réalisation considérés ci-dessus ont été décrits à titre d'exemples non limitatifs, et que d'autres variantes sont par conséquent envisageables.

## Revendications

1. Procédé de fabrication d'un élément de fixation micromécanique comprenant une étape de réalisation d'une ébauche de l'élément de fixation comprenant une tête et une tige reliées l'une à l'autre, suivi d'une étape de formation d'une empreinte dans la tête, ladite étape de formation comprenant une opération d'usinage de l'empreinte, réalisée avec un organe de coupe (11), **caractérisé en ce que** ladite étape de formation comprend également une opération de matage d'une surface cible de l'empreinte, réalisée avec un organe de matage (12), l'organe de coupe (11) et l'organe de matage (12) étant agencés sur un unique outil de mise en forme (10).

2. Procédé selon la revendication 1, dans lequel lors de la réalisation de l'ensemble de l'étape de formation de l'empreinte, l'élément de fixation est maintenu dans une même position, seul l'outil de mise en forme (10) étant déplacé.

3. Procédé selon la revendication 1 ou 2, dans lequel la surface cible matée est une surface de fond de l'empreinte, l'opération de matage étant réalisée de sorte que ladite surface de fond présente un Ra compris entre 0.01 µm et 0.1 µm à l'issue de l'étape de formation.

4. Procédé selon la revendication 1, dans lequel lors de la mise en œuvre des opérations d'usinage et de matage, l'outil de mise en forme (10) est entraîné dans des sens de rotation différents, l'organe de coupe (11) et l'organe de matage (12) étant agencés sur un même disque de l'outil de mise en forme (10).

5. Procédé selon la revendication 1, dans lequel lors des opérations d'usinage et de matage, l'ébauche est usinée par un organe de coupe (11) et matée par un organe de matage (12) formés chacun par un disque de l'outil de mise en forme (10), lesdits disques étant parallèles et coaxiaux.

6. Procédé selon l'une des revendications 1 à 5, dans lequel l'opération de matage est mise en œuvre par une pluralité de passes successives de l'organe de matage (12) sur la surface cible, chaque passe étant réalisée à une profondeur de passe comprise entre 0,1 µm et 2 µm ou entre 0,5 µm et 1,5 µm.

7. Outil de mise en forme (10) pour la réalisation d'une empreinte d'un élément de fixation micromécanique, comprenant un corps s'étendant selon un axe longitudinal autour duquel l'outil est destiné à être entraîné en rotation, l'outil comportant, agencés à une extrémité longitudinale du corps, un organe de coupe (11) comprenant une arête de coupe destinée à enlever de la matière d'un élément de fixation de sorte à générer une empreinte lorsque l'outil est entraîné en rotation, et un organe de matage (12) comprenant une surface active (120) destinée à mater une surface cible de l'empreinte lorsque l'outil est entraîné en rotation, outil **caractérisé en ce que** chacun des organes de coupe et de matage (11, 12) est sous la forme d'un disque, les disques étant agencés parallèlement et coaxialement, les arêtes de coupe (110) et la surface active (120) étant respectivement agencées en périphérie desdits disques.

8. Outil de mise en forme (10) selon la revendication 7, dans lequel la surface active (120) de l'organe de matage (12) présente une section droite de forme circulaire.

9. Outil de mise en forme (10) selon la revendication 8, dans lequel la surface active (120) de l'organe de matage (12) présente une section droite de forme polygonale, comprenant des segments (122) reliés entre eux par des sommets (121) arrondis.

10. Outil de mise en forme (10) selon la revendication 8 ou 9, dans lequel les segments (122) présentent une courbure concave.

## Patentansprüche

1. Verfahren zur Herstellung eines mikromechanischen Befestigungselements
umfassend einen Schritt zur Herstellung eines
Rohlings des Befestigungselements, umfassend einen Kopf und einen Schaft, die miteinander verbunden sind, gefolgt von einem Schritt zur Ausbildung eines Abdrucks im Kopf, wobei der Ausbildungsschritt eine Bearbeitungsaktion des Abdrucks umfasst, die mit einem Schneidorgan (11) durchgeführt wird, **dadurch gekennzeichnet, dass** der Ausbildungsschritt außerdem eine Aktion zum
Verstemmen einer Zieloberfläche des Abdrucks umfasst, durchgeführt mit einem Verstemmorgan (12), wobei das Schneidorgan (11) und das Verstemmorgan (12) auf einem einzigen Umformwerkzeug (10) angeordnet sind.

2. Verfahren nach Anspruch 1, wobei bei der Durchführung des gesamten Schritts zur Herstellung des Abdrucks das Befestigungselement in derselben Position gehalten wird, wobei nur das Umformwerkzeug (10) bewegt wird.

3. Verfahren nach Anspruch 1 oder 2, wobei die verstemmte Zielfläche eine Bodenfläche des Abdrucks ist, wobei die Verstemmaktion so durchgeführt wird, dass diese Bodenfläche am Ende des Ausbildungsschritts ein Ra zwischen 0,01 pm und 0,1 pm aufweist.

4. Verfahren nach Anspruch 1, wobei bei der Durchführung der Bearbeitungs- und Verstemmaktion das Umformwerkzeug (10) in unterschiedlichen Drehrichtungen angetrieben wird, wobei das Schneidorgan (11) und das Verstemmorgan (12) auf einer einzigen Scheibe des Umformwerkzeugs (10) angeordnet sind.

5. Verfahren nach Anspruch 1, wobei bei den Bearbeitungs- und Verstemmaktionen der Rohling durch ein Schneidorgan (11) bearbeitet und durch ein Verstemmorgan (12) verstemmt wird, die jeweils durch eine Scheibe des Umformwerkzeugs (10) gebildet sind, wobei diese Scheiben parallel und koaxial sind.

6. Verfahren nach einem der Ansprüche 1 bis 5, wobei die Verstemmaktion durch eine Mehrzahl aufeinanderfolgender Durchgänge des Verstemmorgans (12) über die Zielfläche durchgeführt wird, wobei jeder Durchgang mit einer Zustelltiefe zwischen 0,1 pm und 2 pm oder zwischen 0,5 pm und 1,5 pm durchgeführt wird.

7. Umformwerkzeug (10) zur Herstellung eines Abdrucks eines mikromechanischen Befestigungselements, umfassend einen sich entlang einer Längsachse erstreckenden Körper, um den das Werkzeug zur Rotation angetrieben werden soll, wobei das Werkzeug, an einem Längsende des Körpers angeordnet, ein Schneidorgan (11) umfasst, das eine Schneidkante aufweist, die dazu bestimmt ist, Material von einem Befestigungselement zu entfernen, um einen Abdruck zu erzeugen, wenn das Werkzeug in Rotation angetrieben wird, und ein Verstemmorgan (12) umfasst, das eine aktive Oberfläche (120) aufweist, die dazu bestimmt ist, eine Zieloberfläche des Abdrucks zu verstemmen, wenn das Werkzeug in Rotation angetrieben wird, **dadurch gekennzeichnet, dass** jedes der Schneid- und Verstemmorgane (11, 12) in Form einer Scheibe ausgebildet ist, wobei die Scheiben parallel und koaxial angeordnet sind, wobei die Schneidkanten (110) bzw. die aktive Oberfläche (120) am Umfang der Scheiben angeordnet sind

8. Umformwerkzeug (10) nach Anspruch 7, wobei die aktive Oberfläche (120) des Verstemmorgans (12) einen kreisförmigen Querschnitt aufweist.

9. Umformwerkzeug (10) nach Anspruch 8, wobei die aktive Oberfläche (120) des Verstemmorgans (12) einen polygonförmigen Querschnitt aufweist, umfassend Segmente (122), die durch abgerundete Eckpunkte (121) miteinander verbunden sind.

10. Umformwerkzeug (10) nach Anspruch 8 oder 9, wobei die Segmente (122) eine konkave Krümmung aufweisen.

## Claims

1. A method for manufacturing a micromechanical fastening element comprising a step of producing a blank of the fastening element comprising a head and a shank connected to each other, followed by a step of forming an impression in the head, said forming step comprising an operation of machining the impression, carried out with a cutting member (11), **characterised in that** said forming step also comprises an operation of matting a target surface of the impression, carried out with a matting member (12), the cutting member (11) and the matting member (12) being arranged on a single shaping tool (10).

2. The method according to claim 1, wherein when carrying out the entire impression forming step, the fastening element is held in the same position, only the shaping tool (10) being moved.

3. The method according to claim 1 or 2, wherein the matted target surface is a back surface of the impression, the matting operation being carried out so that said back surface has a Ra comprised between 0.01 µm and 0.1 µm at the end of the forming step.

4. The method according to claim 1, wherein, when carrying out the machining and matting operations, the shaping tool (10) is driven in different directions of rotation, the cutting member (11) and the matting member (12) being arranged on the same disc of the shaping tool (10).

5. The method according to claim 1, wherein during the machining and matting operations, the blank is machined by a cutting member (11) and matted by a matting member (12) each formed by a disc of the shaping tool (10), said discs being parallel and coaxial.

6. The method according to one of claims 1 to 5, wherein the matting operation is carried out by a plurality of successive passes of the matting member (12) over the target surface, each pass being carried out to a pass depth comprised between 0.1 µm and 2 µm or between 0.5 µm and 1.5 µm.

7. A shaping tool (10) for producing an impression of a micromechanical fastening element, comprising a body extending along a longitudinal axis about which the tool is intended to be rotated, the tool including, arranged at a longitudinal end of the body, a cutting member (11) comprising a cutting edge intended to remove material from a fastening element so as to generate an impression when the tool is rotated, and a matting member (12) comprising an active surface (120) intended for matting a target surface of the impression when the tool is rotated, tool **characterised in that** each of the cutting and matting members (11, 12) is in the form of a disc, the discs being arranged in parallel and coaxially, the cutting edges (110) and the active surface (120) being respectively arranged at the periphery of said discs.

8. The shaping tool (10) according to claim 7, wherein the active surface (120) of the matting member (12) has a circular cross-section.

9. The shaping tool (10) according to claim 8, wherein the active surface (120) of the matting member (12) has a polygonal cross-section, comprising segments (122) joined together by rounded vertices (121).

10. The shaping tool (10) according to claim 8 or 9, wherein the segments (122) have a concave curvature.
